# EUROPEAN PATENT SPECIFICATION

(11) **EP 3 731 347 B1**
(45) Date of publication and mention of the grant of the patent: **14.12.2022**
(21) Application number: 20170430.1
(22) Date of filing: 20.04.2020
(51) Int. Cl.: H01R 12/70, H01R 12/71, H01R 13/24, F21V 23/06, F21V 33/00, F25D 25/02, H01R 12/58, H01R 12/73, F25D 27/00, H05K 1/18, H05K 3/36, F21W 131/301, F21Y 115/10

(54) **ELECTRICAL APPARATUS**
ELEKTRISCHE VORRICHTUNG
APPAREIL ÉLECTRIQUE

(30) Priority: 25.04.2019 CN 201910340462
(43) Date of publication of application: 28.10.2020
(73) Proprietor: Tyco Electronics Japan G.K., Takatsu-ku Kawasaki Kanagawa 213-8535 (JP); Tyco Electronics (Shanghai) Co., Ltd., Shanghai (CN)
(72) Inventor: Sakai, Ken, Kawasaki-shi, Kanagawa 213-8535 (JP); Rajendra, Pai R, Shanghai 200233 (CN); Feng, Yulin, Shanghai 200233 (CN); Pan, Lei, Shanghai, 200233 (CN); Xia, Tian, Shanghai 200233 (CN)
(74) Representative: Johnstone, Douglas Ian

(56) References cited:
- EP-A1- 0 902 994
- EP-A1- 2 822 102
- EP-A2- 2 765 377
- DE-A1-102009 002 502
- DE-U1- 20 107 605
- US-A1- 2011 287 641
- US-A1- 2012 052 733
- US-B1- 7 357 665

## Description

### BACKGROUND OF THE INVENTION

### Field of the Invention

The present invention relates to an electrical apparatus comprising an electrical connection assembly.

### Description of the Related Art

In a household appliance, some electrical loads are installed on a movable part, for example, LED lamps installed on a movable shelf in a refrigerator. In the prior art, it is necessary to provide a connector on a circuit board and a mating connector on the movable shelf. After the movable shelf is inserted into the refrigerator, the connector on the circuit board is mated with the mating connector on the movable shelf, so that the circuit board is electrically connected to the LED lamp on the movable shelf by the connector and the mating connector to supply power to the LED lamp.

In the prior art, it is necessary to provide a connector on the movable shelf, which increases the cost. Furthermore, the connector provided on the movable shelf may be damaged during inserting the movable shelf into the refrigerator, which may result in a failure of an electrical connection.

Patents US 2011/0287641 A1, US 2012/0052733 A1, US 7357665 B1 and EP 2822102 A1 all relate to connectors for connection to a circuit board. Each connector includes a housing which accommodates contacts each of which includes a connection end for electrical connection with the circuit board at a first face of the housing and an elastic arm that extends from a second face which is perpendicular to the first face. Patents DE 201 07 605 U1 and WO 97/45900 A1 disclose similar connectors in which the second face is on the opposite side of the housing to the first face. Patent DE 10 2009 002 502 A1 discloses a refrigerator with ferromagnetic support projections which project from side-walls thereof to the undersides of which lighting units are connected by means of magnets on the lighting units which also act as electrical contact elements. The support projections also support shelves which rest on the support projections.

Patent EP 2 765 377 A2 also discloses an electrical apparatus, more particularly also a refrigerator, comprising an electrical connection assembly fixed in the electrical apparatus, the electrical connection assembly comprising a plurality of connectors separated from each other in a vertical direction, wherein each connector comprises at least one contact; the apparatus further comprising a plurality of movable shelves adapted to be inserted into the electrical apparatus in a horizontal direction; and an electrical load mounted on each movable shelf, wherein an electrical contact pad serves as an electrode terminal of the electrical load, wherein the plurality of connectors are adapted to make electrical contact with the plurality of movable shelves respectively, wherein when the movable shelf is inserted into the electrical apparatus, the electrical contact pad makes electrical contact with the contact of the respective connector of the electrical connection assembly.

### SUMMARY OF THE INVENTION

The present invention has been made to overcome or alleviate at least one aspect of the above mentioned disadvantages.

According to the invention there is provided an electrical apparatus as claimed in claim 1.

A plurality of connectors are mounted on the circuit board, and the plurality of connectors are separated from each other in a first direction for making electrical contact with electrical contact pads on a plurality of movable shelves, respectively.

According to the present invention, the plurality of connectors are arranged in a column along the first direction on the circuit board.

According to another exemplary embodiment of the present invention, the surface of the housing is configured to be perpendicular to the circuit board, and/or the side face of the housing is configured to be parallel to the circuit board.

According to another exemplary embodiment of the present invention, the first direction is parallel to the circuit board and perpendicular to the surface of the housing.

According to another exemplary embodiment of the present invention, the connector is a power supply connector, and each connector includes two contacts; two electrical contact pads are formed on a surface of the movable shelf, and the two electrical contact pads serve as two electrode terminals of an electrical load mounted on the movable shelf; the elastic arms of the two contacts of the connector are adapted to make electrical contact with the two electrical contact pads of the movable shelf, respectively, so as to connect the electrical load on the movable shelf to the circuit board to power the electrical load.

According to another exemplary embodiment of the present invention, at least one chamber is formed in the housing, and/or the at least one contact is received in the at least one chamber, respectively.

According to another exemplary embodiment of the present invention, each contact further comprises a base plate, the elastic arm is connected to an end of the base plate, and/or the connection pin is connected to a side of the base plate.

According to another exemplary embodiment of the present invention, each contact further comprises a pair of side wings connected to both sides of the base plate, respectively; two slots corresponding to the pair of side wings are formed in both inner sidewalls of the chamber of the housing, and/or the side wing is inserted into the slot in an interference fit to fix the contact in the housing.

According to another exemplary embodiment of the present invention, a positioning slot corresponding to the connection pin is formed in the housing, and/or the connection pin passes through the positioning slot and is positioned in the positioning slot.

According to another exemplary embodiment of the present invention, a hole corresponding to the connection pin is formed in the circuit board, the connection pin is inserted into the hole and soldered to the circuit board.

According to another exemplary embodiment of the present invention, a positioning post is formed on the side face of the housing, a positioning hole corresponding to the positioning post is formed in the circuit board, and/or the positioning post is inserted into the positioning post in an interference fit to fix the housing to the circuit board.

According to another exemplary embodiment of the present invention, the elastic arm of the contact has an arc contact portion protruding outward, and the arc contact portion is adapted to make electrical contact with the electrical contact pad on the movable shelf.

According to another exemplary embodiment of the present invention, the electrical load comprises an LED lamp embedded in the movable shelf.

According to another exemplary embodiment of the present invention, the electrical apparatus is a refrigerator, and the movable shelf is a movable shelf of the refrigerator for placing objects on.

In the above various exemplary embodiments of the present invention, the connector mounted on the circuit board is adapted to make electrical contact with the electrical contact pad formed on the movable shelf, whereby the electrical load on the movable shelf may be electrically connected to the circuit board by the electrical contact pad on the movable shelf without a need to provide a connector on the movable shelf, which reduces the cost, and is very convenient to use.

### BRIEF DESCRIPTION OF THE DRAWINGS

The above and other features of the present invention will become more apparent by describing in detail exemplary embodiments thereof with reference to the accompanying drawings, in which:
Fig.1 is an illustrative exploded view of a connector for use in an apparatus according to the present invention;
Fig.2 is an illustrative assembled view of the connector shown in Fig. 1;
Fig.3 shows an illustrative perspective view of the connector shown in Fig. 2 when viewed from the bottom;
Fig.4 is a cross section view of the connector shown in Fig.2;
Fig.5 is an illustrative perspective view of an electrical connection assembly for use in an apparatus according to the present invention;
Fig.6 is an enlarged local view of the electrical connection assembly of Fig.5; and
Fig.7 is an enlarged local view of the electrical connection assembly of Fig.5 when viewed from a back side of a circuit board.

### DETAILED DESCRIPTION OF PREFERRED EMBODIMENTS OF THE

### INVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

An electrical connection assembly for use in an apparatus according to the invention, comprises: a circuit board; and at least one connector mounted on the circuit board. Each connector comprises a housing and at least one contact received in the housing. Each contact comprising: an elastic arm extending out from a surface of the housing to make electrical contact with an electrical contact pad formed on a movable shelf; and a connection pin extending out from a side face of the housing to electrically connect with the circuit board.

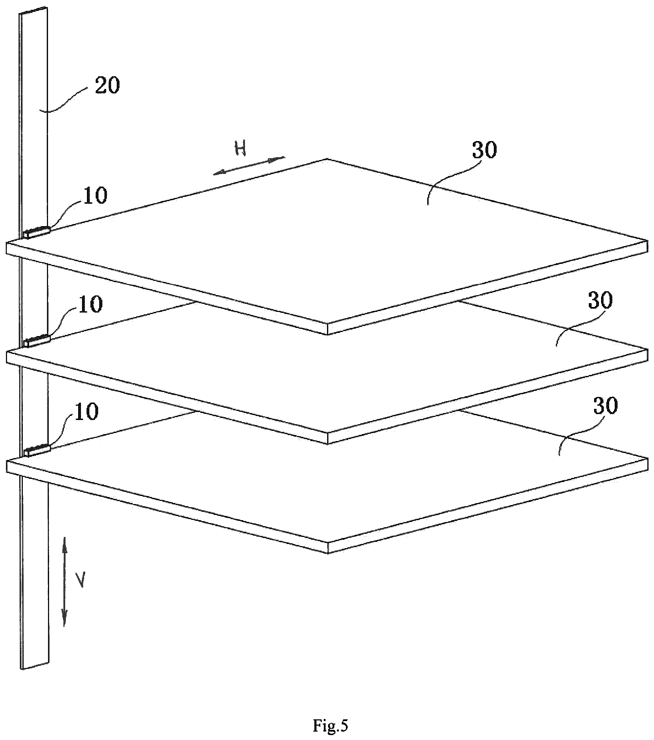

Fig.5 is an illustrative perspective view of an electrical connection assembly for use in an apparatus according to the invention.

As shown in Fig.5, the electrical connection assembly comprises a circuit board 20 and at least one connector 10 mounted on the circuit board 20.

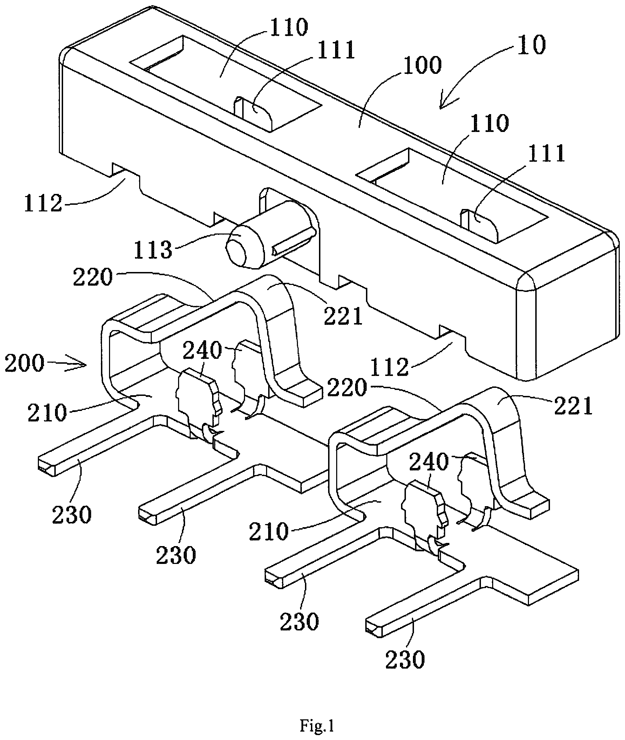

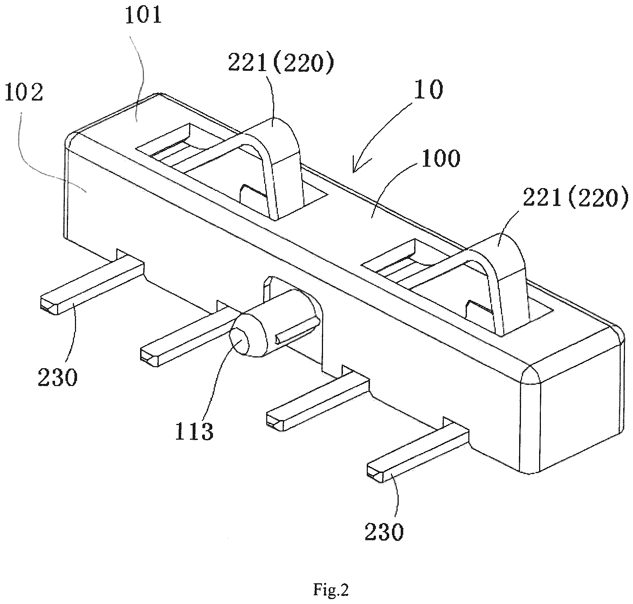

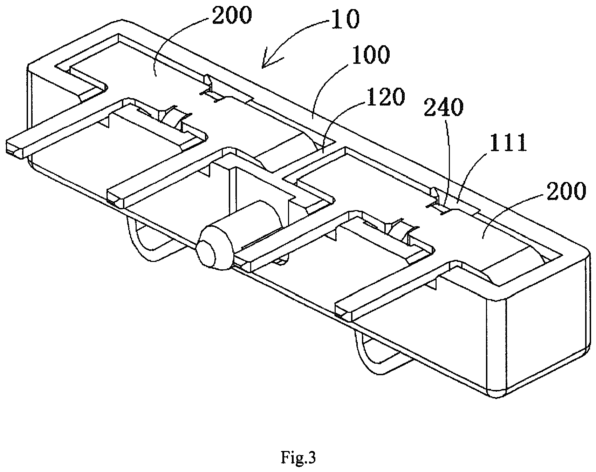

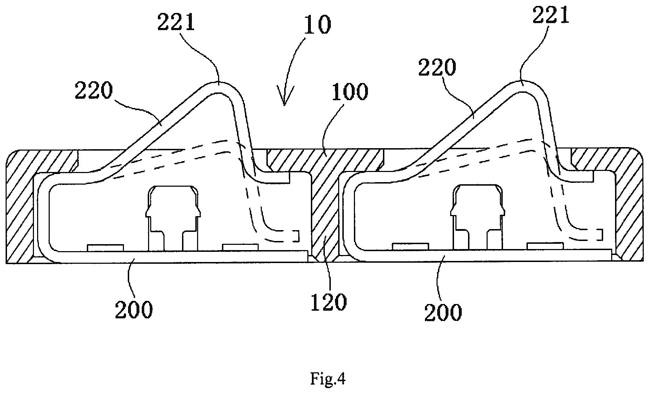

Fig.1 is an illustrative exploded view of a connector 10 according to an exemplary embodiment of the present invention; Fig.2 is an illustrative assembled view of a connector 10 according to an exemplary embodiment of the present invention; Fig.3 shows an illustrative perspective view of the connector 10 shown in Fig. 2 when viewed from the bottom; Fig.4 is a cross section view of the connector 10 shown in Fig.2.

As shown in Figs. 1-5, in an embodiment, each connector 10 comprises a housing 100 and at least one contact 200 received in the housing 100.

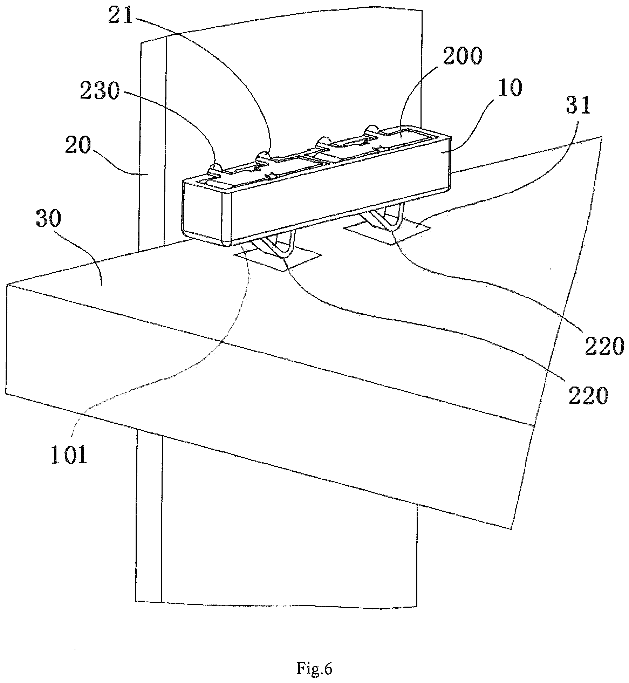

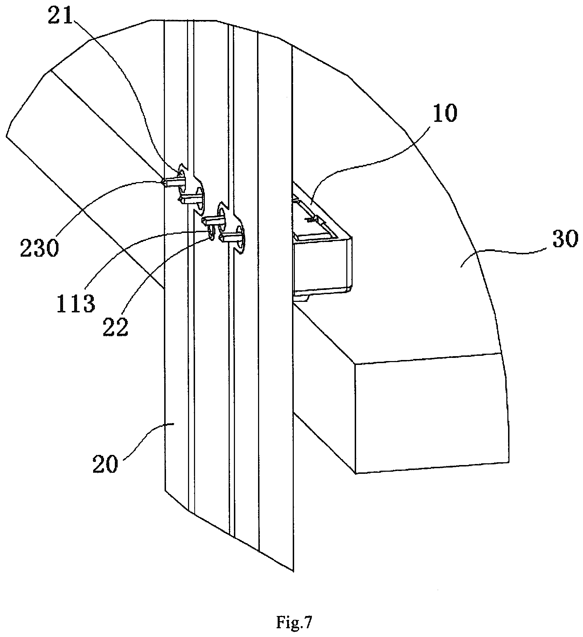

Fig.6 is an enlarged local view of the electrical connection assembly of Fig.5; and Fig.7 is an enlarged local view of the electrical connection assembly of Fig.5 when viewed from back side of a circuit board 20.

As shown in Figs.1-7, each contact 200 comprises an elastic arm 220 and a connection pin 230. The elastic arm 220 extends out from a surface of the housing 100 to make electrical contact with an electrical contact pad 31 formed on a movable shelf 30. The connection pin 230 extends out from a side face of the housing 100 to electrically connect with the circuit board 20.

As shown in Figs. 1-7, a plurality of connectors 10 are mounted on the circuit board 20. The plurality of connectors 10 are separated from each other in a first or vertical direction V for electrically contact with electrical contact pads 31 on a plurality of movable shelves 30, respectively.

As shown in Figs. 1-7, the plurality of connectors 10 are arranged in a column along the first direction on the circuit board 20.

As shown in Figs. 1-7, in an embodiment, the surface of the housing 100 is configured to be perpendicular to the circuit board 20, and the elastic arm 220 extends out from a first surface 101 of the housing 100. A side face 102 of the housing 100 is configured to be parallel to the circuit board 20, and the connection pin 230 extends out from the side face of the housing 100.

As shown in Figs.1-7, the circuit board 20 is vertically arranged. Therefore, the circuit board 20 is in a vertical plane. The first surface 101 of the housing 100 is in a horizontal plane. Thereby, the circuit board 20 is perpendicular to the first surface 101 of the housing 100 and parallel to the side face 102 of the housing 100.

As shown in Figs. 1-7, in an embodiment, the connector 10 is a power supply connector, and each connector 10 includes two contacts 200. Two electrical contact pads 31 are formed on a surface of the movable shelf 30, and the two electrical contact pads 31 serve as two electrode terminals of an electrical load (not shown) mounted on the movable shelf 30. The elastic arms 220 of the two contacts 200 of the connector 10 are adapted to make electrical contact with the two electrical contact pads 31 of the movable shelf 30, respectively, so as to connect the electrical load on the movable shelf 30 to the circuit board 20 to power the electrical load.

As shown in Figs. 1-7, in an embodiment, at least one chamber 110 is formed in the housing 100, the at least one contact 200 is received in the at least one chamber 110, respectively. In the illustrated embodiment, two chambers 110 are formed in the housing 100 and isolated from each other by a separation wall 120. The two contacts 200 of the connector 10 are received in the two chambers 110, respectively.

As shown in Figs. 1-7, in an embodiment, each contact 200 further comprises a base plate 210. The elastic arm 220 is connected to an end of the base plate 210, and the connection pin 230 is connected to or forms an integral extension of a side of the base plate 210.

As shown in Figs. 1-7, in an embodiment, each contact 200 further comprises a pair of side wings 240 connected to or forming integral extensions of both sides of the base plate 210, respectively. Two slots 111 corresponding to the pair of side wings 240 are formed in both inner sidewalls of the chamber 110 of the housing 100, and/or the side wings 240 are inserted into the slots 111 in an interference fit to fix the contact 200 in the housing 100.

As shown in Figs. 1-7, in an embodiment, a positioning slot 112 corresponding to the connection pin 230 is formed in the housing 100, and/or the connection pin 230 passes through the positioning slot 112 and is positioned in the positioning slot 112.

As shown in Figs. 1-7, in an embodiment, a hole 21 corresponding to the or each connection pin 230 is formed in the circuit board 20, and/or the connection pin 230 is inserted into the respective hole 21 and is soldered to the circuit board 20.

As shown in Figs. 1-7, in an embodiment, a positioning post 113 is formed on the side face 102 of the housing 100, and a positioning hole 22 corresponding to the positioning post 113 is formed in the circuit board 20, and/or the positioning post 113 is inserted into the positioning hole 22 in an interference fit to fix the housing 100 to the circuit board 20.

As shown in Figs. 1-7, in an embodiment, the elastic arm 220 of the contact 200 has an arcuate contact portion 221 protruding outward, and the arcuate contact portion 221 is adapted to make electrical contact with the electrical contact pad 31 on the movable shelf 30.

In another exemplary embodiment of the present invention, there is also provided an electrical apparatus. As shown in Figs. 1-7, in an embodiment, the electrical apparatus mainly comprises the above electrical connection assembly, a movable shelf 30, and an electrical load (not shown). The electrical connection assembly may be fixed in the electrical apparatus. The movable shelf 30 is adapted to be inserted into the electrical apparatus. The electrical load is mounted on the movable shelf 30 and moved with the movable shelf 30.

As shown in Figs.1-7, in an embodiment, an electrical contact pad 31 served as an electrode terminal of the electrical load is formed on a surface of the movable shelf 30. In this case, when the movable shelf 30 is inserted into the electrical apparatus, the electrical contact pad 31 on the movable shelf 30 electrically contacts with the contact 200 of the connector 10 of the electrical connection assembly. In this way, the electrical load on the movable shelf 30 is electrically connected to the circuit board 20, so as to power the electrical load.

As shown in Fig.4, in an embodiment, before the movable shelf 30 is inserted into the electrical apparatus, the elastic arm 220 of the contact 200 of the connector is not pressed by the movable shelf 30 and is located at an initial position shown by the solid line.

As shown in Fig.4, in an embodiment, after the movable shelf 30 is inserted into the electrical apparatus, the elastic arm 220 of the contact 200 of the connector is pressed by the movable shelf 30 and is moved to a working position shown by the dotted line.

As shown in Figs. 1-7, in an embodiment, the circuit board 20 is disposed vertically in the electrical apparatus, a plurality of connectors 10 are mounted on the circuit board 20 and separated from each other in the vertical direction V. The electrical apparatus comprises a plurality of movable shelves 30 each adapted to be inserted into the electrical apparatus in a horizontal direction H. The plurality of connectors 10 are adapted to make electrical contact with the electrical contact pads 31 on the plurality of movable shelves 30, respectively.

Although it is not shown, in an exemplary embodiment of the present invention, the electrical load may comprise a LED lamp embedded in the movable shelf 30.

As shown in Figs. 1-7, in an embodiment, the electrical apparatus may comprise but not limited to a refrigerator, and the movable shelf 30 may be a movable shelf of the refrigerator for placing objects on.

Although it is not shown, in an exemplary embodiment of the present invention, the movable shelf may be supported by supporters formed in the refrigerator.

In an embodiment, since the movable shelf 30 does not have a separate connector mounted thereon, it can be washed.

And in an embodiment, if the position of the holes 21 in the circuit board 20 is changed in the first direction V, an interval between adjacent connectors 10 is changed so that an interval between adjacent movable shelves can be changed.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles of the disclosure, the scope of which is defined in the claims.

## Claims

1. An electrical apparatus, for example a household appliance such as a refrigerator, comprising an electrical connection assembly (10, 20) fixed in the electrical apparatus, the electrical connection assembly, comprising:
a circuit board (20) orientated vertically (V) in the electrical apparatus; and
a plurality of connectors (10) mounted on the circuit board (20) and separated from each other in a vertical direction (V),
wherein each connector (10) comprises a housing (100) and at least one contact (200) received in the housing (100),
wherein each of the at least one contact (200) comprises:
an elastic arm (220) extending out from a first surface (101) of the housing (100) configured to make electrical contact with an electrical contact pad (31) formed on a movable shelf (30); and
a connection pin (230) extending out from a side face (102) of the housing (100) to electrically connect with the circuit board (20),
the electrical apparatus further comprising:
a plurality of movable shelves (30) adapted to be inserted into the electrical apparatus in a horizontal direction; and
an electrical load mounted on each movable shelf (30),
wherein an electrical contact pad (31) serves as an electrode terminal of the electrical load and is formed on a surface of the respective movable shelf (30),
wherein the plurality of connectors (10) are adapted to make electrical contact with the plurality of movable shelves (30) respectively,
wherein when the movable shelf (30) is inserted into the electrical apparatus, the electrical contact pad (31) on the movable shelf (30) makes electrical contact with the contact (200) of the respective connector (10) of the electrical connection assembly.

2. The electrical apparatus according to claim 1,
wherein the first surface (101) of each housing (100) is configured to be perpendicular to the circuit board (20), and the side face (102) of the housing (100) is configured to be parallel to the circuit board (20).

3. The electrical apparatus according to claim 1 or 2,
wherein the first direction (V) is parallel to the circuit board (20) and perpendicular to the first surface (101) of the housing (100).

4. The electrical apparatus according to any preceding claim,
wherein each connector (10) is a power supply connector, and each connector (10) includes two contacts (200);
wherein two electrical contact pads (31) are formed on a surface of each movable shelf (30), and the two electrical contact pads (31) serve as two electrode terminals of an electrical load mounted on the movable shelf (30);
wherein the elastic arms (220) of the two contacts (200) of the respective connector (10) are adapted to make electrical contact with the two electrical contact pads (31) of the respective movable shelf (30), respectively, so as to connect the electrical load on the movable shelf (30) to the circuit board (20) to power the respective electrical load.

5. The electrical apparatus according to any preceding claim,
wherein for each connector (10) at least one chamber (110) is formed in the housing (100), and the at least one contact (200) is received in the at least one chamber (110), respectively.

6. The electrical apparatus according to claim 5,
wherein the or each contact (200) further comprises a base plate (210), the elastic arm (220) is connected to an end of the base plate (210), and the connection pin (230) is connected to a side of the base plate (210).

7. The electrical apparatus according to claim 5 or 6,
wherein each contact (200) further comprises a pair of side wings (240) connected to both sides of the base plate (210), respectively; and
wherein two slots (111) corresponding to the pair of side wings (240) are formed in both inner sidewalls of the respective chamber (110) of the respective housing (100), and the side wing (240) is inserted into the slot (111) in an interference fit to fix the respective contact (200) in the respective housing (100).

8. The electrical apparatus according to any preceding claim,
wherein a positioning slot (112) corresponding to the or each connection pin (230) is formed in the housing (100), and the connection pin (230) passes through the positioning slot (112) and is positioned in the positioning slot (112).

9. The electrical apparatus according to any preceding claim,
wherein a hole (21) corresponding to the connection pin (230) is formed in the circuit board (20), and the connection pin (230) is inserted into the hole (21) and soldered to the circuit board (20).

10. The electrical apparatus according to claim 1,
wherein for the or each connector a positioning post (113) is formed on the side face (102) of the housing (100), a positioning hole (22) corresponding to the positioning post (113) is formed in the circuit board (20), and the positioning post (113) is inserted into the positioning hole (22) in an interference fit to fix the housing (100) to the circuit board (20).

11. The electrical connection assembly according to any preceding claim,
wherein for the or each contact (200) the elastic arm (220) of the contact (200) has an arcuate contact portion (221) protruding outwardly, and the arcuate contact portion (221) is adapted to make electrical contact with the respective electrical contact pad (31) on the respective movable shelf (30).

12. The electrical apparatus according to any preceding claim, wherein the electrical load comprises an LED lamp embedded in the movable shelf (30).

13. The electrical apparatus according to any preceding claim,
wherein the electrical apparatus is a refrigerator, and the movable shelf (30) is a movable shelf of the refrigerator for placing objects on.

## Patentansprüche

1. Elektrische Vorrichtung, zum Beispiel ein Haushaltsgerät wie ein Kühlschrank, die Folgendes umfasst:
eine in der elektrischen Vorrichtung befestigte elektrische Verbindungsanordnung (10, 20), wobei die elektrische Verbindungsanordnung Folgendes umfasst:
eine Leiterplatte (20), die vertikal (V) in der elektrischen Vorrichtung orientiert ist; und
mehrere Verbinder (10), die auf der Leiterplatte (20) montiert und in einer vertikalen Richtung (V) voneinander getrennt sind,
wobei jeder Verbinder (10) ein Gehäuse (100) und mindestens einen in dem Gehäuse (100) aufgenommenen Kontakt (200) aufweist,
wobei jeder der mindestens einen Kontakte (200) Folgendes umfasst:
einen elastischen Arm (220), der sich von einer ersten Oberfläche (101) des Gehäuses (100) nach außen erstreckt und zum Herstellen eines elektrischen Kontakts mit einem auf einem beweglichen Fach (30) ausgebildeten elektrischen Kontaktfeld (31) konfiguriert ist; und
einen Verbindungsstift (230), der sich von einer Seitenfläche (102) des Gehäuses (100) für eine elektrische Verbindung mit der Leiterplatte (20) nach außen erstreckt,
wobei die elektrische Vorrichtung ferner Folgendes umfasst:
mehrere bewegliche Fächer (30), die zum Einsetzen in die elektrische Vorrichtung in einer horizontalen Richtung ausgelegt sind; und
eine auf jedem beweglichen Fach (30) montierte elektrische Last,
wobei ein elektrisches Kontaktfeld (31) als ein Elektrodenanschluss der elektrischen Last dient und auf einer Oberfläche des jeweiligen beweglichen Fachs (30) ausgebildet ist,
wobei die mehreren Verbinder (10) zum Herstellen jeweils eines elektrischen Kontakts mit den mehreren beweglichen Fächern (30) ausgelegt ist,
wobei, wenn das bewegliche Fach (30) in die elektrische Vorrichtung eingesetzt wird, das elektrische Kontaktfeld (31) auf dem beweglichen Fach (30) einen elektrischen Kontakt mit dem Kontakt (200) des jeweiligen Verbinders (10) der elektrischen Verbindungsanordnung herstellt.

2. Elektrische Vorrichtung nach Anspruch 1,
wobei die erste Oberfläche (101) jedes Gehäuses (100) so konfiguriert ist, dass sie lotrecht zur Leiterplatte (20) ist, und die Seitenfläche (102) des Gehäuses (100) so konfiguriert ist, dass sie parallel zur Leiterplatte (20) ist.

3. Elektrische Vorrichtung nach Anspruch 1 oder 2,
wobei die erste Richtung (V) parallel zur Leiterplatte (20) und lotrecht zur ersten Oberfläche (101) des Gehäuses (100) verläuft.

4. Elektrische Vorrichtung nach einem vorherigen Anspruch,
wobei jeder Verbinder (10) ein Stromversorgungsverbinder ist und jeder Verbinder (10) zwei Kontakte (200) aufweist;
wobei zwei elektrische Kontaktfelder (31) auf einer Oberfläche jedes beweglichen Fachs (30) ausgebildet sind und die zwei elektrischen Kontaktfelder (31) als zwei Elektrodenanschlüsse einer auf dem beweglichen Fach (30) montierten elektrischen Last dienen;
wobei die elastischen Arme (220) der beiden Kontakte (200) des jeweiligen Verbinders (10) zum Herstellen jeweils eines elektrischen Kontakts mit den beiden elektrischen Kontaktfeldern (31) des jeweiligen beweglichen Fachs (30) ausgelegt sind, um die elektrische Last auf dem beweglichen Fach (30) mit der Leiterplatte (20) zu verbinden, um die jeweilige elektrische Last mit Strom zu versorgen.

5. Elektrische Vorrichtung nach einem vorherigen Anspruch,
wobei für jeden Verbinder (10) mindestens eine Kammer (110) in dem Gehäuse (100) ausgebildet ist und der mindestens eine Kontakt (200) jeweils in der mindestens einen Kammer (110) aufgenommen ist.

6. Elektrische Vorrichtung nach Anspruch 5,
wobei der oder jeder Kontakt (200) ferner eine Basisplatte (210) umfasst, der elastische Arm (220) mit einem Ende der Basisplatte (210) verbunden ist und der Verbindungsstift (230) mit einer Seite der Basisplatte (210) verbunden ist.

7. Elektrische Vorrichtung nach Anspruch 5 oder 6,
wobei jeder Kontakt (200) ferner ein Paar Seitenflügel (240) umfasst, die jeweils mit beiden Seiten der Basisplatte (210) verbunden sind; und
wobei zwei Schlitze (111) entsprechend dem Paar Seitenflügel (240) in beiden inneren Seitenwänden der jeweiligen Kammer (110) des jeweiligen Gehäuses (100) ausgebildet sind und der Seitenflügel (240) in den Schlitz (111) in einer Presspassung eingesetzt ist, um den jeweiligen Kontakt (200) in dem jeweiligen Gehäuse (100) zu befestigen.

8. Elektrische Vorrichtung nach einem vorherigen Anspruch,
wobei ein Positionierungsschlitz (112) entsprechend dem oder jedem Verbindungsstift (230) in dem Gehäuse (100) ausgebildet ist und der Verbindungsstift (230) den Positionierungsschlitz (112) durchquert und in dem Positionierungsschlitz (112) positioniert wird.

9. Elektrische Vorrichtung nach einem vorherigen Anspruch,
wobei ein Loch (21) entsprechend dem Verbindungsstift (230) in der Leiterplatte (20) ausgebildet ist und der Verbindungsstift (230) in das Loch (21) eingesetzt und mit der Leiterplatte (20) verlötet ist.

10. Elektrische Vorrichtung nach Anspruch 1,
wobei für den oder jeden Verbinder ein Positionierungspfosten (113) an der Seitenfläche (102) des Gehäuses (100) ausgebildet ist, ein Positionierungsloch (22) entsprechend dem Positionierungspfosten (113) in der Leiterplatte (20) ausgebildet ist und der Positionierungspfosten (113) in das Positionierungsloch (22) in einer Presspassung eingesetzt ist, um das Gehäuse (100) an der Leiterplatte (20) zu befestigen.

11. Elektrische Verbindungsanordnung nach einem vorherigen Anspruch,
wobei für den oder jeden Kontakt (200) der elastische Arm (220) des Kontakts (200) einen bogenförmigen Kontaktabschnitt (221) aufweist, der nach außen vorsteht, und der bogenförmige Kontaktabschnitt (221) zur Herstellung eines elektrischen Kontakts mit dem jeweiligen elektrischen Kontaktfeld (31) auf dem jeweiligen beweglichen Fach (30) ausgelegt ist.

12. Elektrische Vorrichtung nach einem vorherigen Anspruch, wobei die elektrische Last eine in das bewegliche Fach (30) eingebettete LED-Lampe umfasst.

13. Elektrische Vorrichtung nach einem vorherigen Anspruch,
wobei die elektrische Vorrichtung ein Kühlschrank ist und das bewegliche Fach (30) ein bewegliches Fach des Kühlschranks ist, auf dem Gegenstände platziert werden können.

## Revendications

1. Appareil électrique, par exemple un appareil électroménager tel un réfrigérateur, comprenant
un ensemble de connexion électrique (10, 20) fixé dans l'appareil électrique, l'ensemble de connexion électrique comprenant :
une carte de circuits (20) orientée verticalement (V) dans l'appareil électrique ; et
une pluralité de connecteurs (10) montés sur la carte de circuits (20) et séparés les uns des autres suivant un sens vertical (V),
dans lequel chaque connecteur (10) comprend un logement (100) et au moins un contact (200) reçu dans le logement (100),
dans lequel chacun de l'au moins un contact (200) comprend :
un bras élastique (220) s'étendant vers l'extérieur à partir d'une première surface (101) du logement (100) configuré pour établir un contact électrique avec une plage de contact électrique (31) formée sur une étagère amovible (30) ; et
une broche de connexion (230) s'étendant vers l'extérieur à partir d'une face latérale (102) du logement (100) pour se connecter électriquement avec la carte de circuits (20),
l'appareil électrique comprenant en outre :
une pluralité d'étagères amovibles (30) conçues pour être insérées dans l'appareil électrique suivant un sens horizontal ; et
une charge électrique montée sur chaque étagère amovible (30),
dans lequel une plage de contact électrique (31) joue le rôle de borne-électrode de la charge électrique et est formée sur une surface de l'étagère amovible respective (30),
dans lequel la pluralité de connecteurs (10) sont conçus pour établir un contact électrique avec la pluralité d'étagères amovibles (30) respectivement,
dans lequel lorsque l'étagère amovible (30) est insérée dans l'appareil électrique, la plage de contact électrique (31) sur l'étagère amovible (30) établit un contact électrique avec le contact (200) du connecteur respectif (10) de l'ensemble de connexion électrique.

2. Appareil électrique selon la revendication 1,
dans lequel la première surface (101) de chaque logement (100) est configurée de façon à être perpendiculaire à la carte de circuits (20), et la face latérale (102) du logement (100) est configurée de façon à être parallèle à la carte de circuits (20).

3. Appareil électrique selon la revendication 1 ou 2,
dans lequel le premier sens (V) est parallèle à la carte de circuits (20) et perpendiculaire à la première surface (101) du logement (100).

4. Appareil électrique selon n'importe quelle revendication précédente,
dans lequel chaque connecteur (10) est un connecteur d'alimentation en énergie, et chaque connecteur (10) inclut deux contacts (200) ;
dans lequel deux plages de contact électrique (31) sont formées sur une surface de chaque étagère amovible (30), et les deux plages de contact électrique (31) jouent le rôle de deux bornes-électrodes d'une charge électrique montée sur l'étagère amovible (30) ;
dans lequel les bras élastiques (220) des deux contacts (200) du connecteur respectif (10) sont conçus pour établir un contact électrique avec les deux plages de contact électrique (31) de l'étagère amovible respective (30), respectivement, de sorte à connecter la charge électrique sur l'étagère amovible (30) à la carte de circuits (20) afin d'alimenter la charge électrique respective.

5. Appareil électrique selon n'importe quelle revendication précédente,
dans lequel, pour chaque connecteur (10), au moins une chambre (110) est formée dans le logement (100), et l'au moins un contact (200) est reçu dans l'au moins une chambre (110), respectivement.

6. Appareil électrique selon la revendication 5,
dans lequel le ou chaque contact (200) comprend en outre une plaque de base (210), le bras élastique (220) est connecté à une extrémité de la plaque de base (210), et la broche de connexion (230) est connectée à un côté de la plaque de base (210).

7. Appareil électrique selon la revendication 5 ou 6,
dans lequel chaque contact (200) comprend en outre une paire d'ailes latérales (240) raccordées aux deux côtés de la plaque de base (210), respectivement ; et
dans lequel deux fentes (111) correspondant à la paire d'ailes latérales (240) sont formées dans les deux parois latérales internes de la chambre respective (110) du logement respectif (100), et l'aile latérale (240) est insérée dans la fente (111) suivant un ajustement serré afin de fixer le contact respectif (200) dans le logement respectif (100).

8. Appareil électrique selon n'importe quelle revendication précédente,
dans lequel une fente de positionnement (112) correspondant à la ou chaque broche de connexion (230) est formée dans le logement (100), et la broche de connexion (230) passe à travers la fente de positionnement (112) et est positionnée dans la fente de positionnement (112).

9. Appareil électrique selon n'importe quelle revendication précédente,
dans lequel un trou (21) correspondant à la broche de connexion (230) est formé dans la carte de circuits (20), et la broche de connexion (230) est insérée dans le trou (21) et brasée à la carte de circuits (20).

10. Appareil électrique selon la revendication 1,
dans lequel, pour le ou chaque connecteur, un montant de positionnement (113) est formé sur la face latérale (102) du logement (100), un trou de positionnement (22) correspondant au montant de positionnement (113) est formé dans la carte de circuits (20), et le montant de positionnement (113) est inséré dans le trou de positionnement (22) suivant un ajustement serré afin de fixer le logement (100) à la carte de circuits (20).

11. Ensemble de connexion électrique selon n'importe quelle revendication précédente,
dans lequel, pour le ou chaque contact (200), le bras élastique (220) du contact (200) a une portion de contact arquée (221) faisant saillie vers l'extérieur, et la portion de contact arquée (221) est conçue pour établir un contact électrique avec la plage de contact électrique respective (31) sur l'étagère mobile respective (30).

12. Appareil électrique selon n'importe quelle revendication précédente, dans lequel la charge électrique comprend une lampe à DEL qui est incorporée dans l'étagère amovible (30).

13. Appareil électrique selon n'importe quelle revendication précédente,
dans lequel l'appareil électrique est un réfrigérateur, et l'étagère amovible (30) est une étagère amovible du réfrigérateur sur laquelle on peut placer des objets.
